# EUROPEAN PATENT APPLICATION

(11) **EP 1 840 181 A1**
(43) Date of publication of application: **03.10.2007**
(21) Application number: 05799740.5
(22) Date of filing: 21.10.2005
(51) Int. Cl.: C09K 11/06

(54) **ELECTROLUMINESCENT HYBRID MATERIAL COMPRISING A MICROPOROUS OR MESOPOROUS SOLID CONTAINING COVALENTLY-BONDED ORGANIC COMPOUNDS WHICH CONFER ELECTROLUMINESCENT PROPERTIES TO SAME**

(30) Priority: 21.10.2004 ES 200402592
(71) Applicant: Consejo Superior de Investigaciones Cientificas, 28006 Madrid (ES); UNIVERSIDAD POLITECNICA DE VALENCIA, 46022 Valencia (ES)
(72) Inventor: CORMA CANOS, Avelino, Inst. de Tecnología Química, 46022 Valencia (ES); GARCÍA GÓMEZ, Hermenegildo, 46022 Valencia (ES); ALVARO RODRIGUEZ, Mercedes, 46022 Valencia (ES)
(74) Representative: Ungria Lopez, Javier
(86) International application number: PCT/ES2005/070148
(87) International publication number: WO 2006/045875

(57) **Abstract**

The invention relates to an electroluminescent organic-inorganic hybrid material which is **characterised in that** it comprises: at least one microporous or mesoporous solid having a structure that is selected from among the structures of zeolites, porous oxides, molecular sieves, silicoaluminophosphates and aluminosilicates; and at least one organic compound which confers electroluminescent properties thereto. The invention is also **characterised in that** the organic compound is a polycyclic aromatic hydrocarbon, at least part of which is joined to the structure of the microporous or mesoporous solid using covalent bonds. The invention also relates to the method of obtaining said material and to the use thereof.

## Description

### TECHNICAL FIELD OF THE INVENTION

The present invention comes within the technical field of micro- and mesoporous solids such as zeolites, porous oxides, molecular sieves, silicoaluminophosphates and aluminosilicates, combined with organic compounds or metallic complexes, such as condensated polycyclic aromatic compounds, and particularly those aromatic compounds which confer electroluminescent properties.

### STATE OF THE PRIOR ART OF THE INVENTION

Electroluminescence is a property consisting of the emission of light when a compound, or more commonly a series of duly arranged compounds, located between two electrodes, is subjected to a potential difference. Electroluminescence is a physical phenomenon that arises when a recombination of an electron and a positive charge takes place in a molecule. The positive charge is known as an electron hole. The recombination of an electron and a hole produces an excited electron state of the molecule, which relaxes to the ground electron state by means of emitting a photon (equation 1). The relaxation of an electron state by means of the emission of light is a phenomenon known as electroluminescence because the origin of the light emission is a potential difference between two electrodes.

Organic compound + e⁻ + h⁺ → [organic compound]* → organic compound +*hv*ₑₗ

e⁻ mobile electrons
h⁺ electron holes
*hv*ₑₗ electroluminescence photon

The positive electrode absorbs electrons from the material in contact and produces positive holes which migrate towards the negative electrode. The negative electrode injects electrons in the material that is in contact with it and produces electrons. These migrate toward the positive electrode. In order to favour the creation of holes and electrons and their migration, it is common in the state of the art relating to electroluminescent cells to place some films in contact with the electrodes, having a thickness of the order of microns and made of suitable materials for accepting holes or electrons. Between these films a layer of an intermediate electroluminescent material is placed between the injector layer of holes and the injector for electrons, which is where the collapse of holes and electrons takes place and where the recombination is produced. One of the electrodes (generally the anode) is a transparent electrode which permits the light generated in the electroluminescence phenomenon to be visible from outside the cell.

Included among electroluminescent materials are organic compounds. As electroluminescent materials, organic compounds present the advantage over inorganics of having a greater ease of synthesis and purification along with the possibility of easily modifying the emission wavelength by means of the introduction of appropriate substituents. Of special importance in the present invention is the fact that polycyclic aromatic compounds exhibit the phenomenon of electroluminescence. Charge transfer complexes between a donor compound and a charge acceptor, where a polycyclic aromatic compound intervenes, are also electroluminescent materials. For a full list of this type of compound, consult Table 2, page 3021, of the reference M. M. Richter, Electroluminescence, Chem. Rev. 2004, 104, 3003-3036.

One of the main drawbacks of organic compounds as electroluminescent materials is their durability, since they undergo decomposition due to attack by atmospheric components. This decomposition is particularly important during the operation of the electroluminescent cell. Oxygen is a notably negative agent in the electroluminescence of organic compounds. On the one hand, it can trap the radical ions involved in the electroluminescence, triggering their degradation, and on the other hand it can inhibit the emissive relaxation of the excited electron state by means of inhibition phenomena. In particular, the deactivation of triplet excited states by oxygen by means of an energy transfer process is very well known in the field of organic photochemistry since it serves to generate singlet oxygen.

Spanish patent application P200201588 describes an electroluminescent material in which an electroluminescent compound selected from among polyphenylenevinylene derivatives, metal ion complexes of the 3A group with ■-hydroxyquinoline, and combinations thereof, are housed in interior spaces of a matrix composed of micro- and/or mesoporous materials, such as zeolites, porous oxides, molecular sieves, silicoaluminophosphates and aluminosilicates. In this prior art there does not exist any covalent bond between the organic compound and the inorganic structure which acts as a matrix.

Moreover, the preparation of structured mesoporous organic-inorganic hybrid materials is also known. These materials can be prepared starting from organosiliceous compounds in the absence of or in combination with tetramethyl orthosilicate or tetraethyl orthosilicate. The hydrolysis of these compounds with trialcoxysilane groups under acidic or basic pH conditions produces the polymerisation of the monomer with the formation of the silicate containing organic compounds. The synthesis of these materials requires a surfactant compound or structure directing agent which, in aqueous medium, creates the first spatial inhomogeneity in a way that is regular but non-rigid. Around the surfactant in aqueous medium, the condensation/polymerisation of the organosiliceous compound takes place, or the co-condensation of this organosiliceous compound and of the orthosilicate. The surfactant agents most commonly used are cetyltrimethylammonium bromide and the copolymer of ethyleneglycol and propyleneglycol forming blocks. Pluronic is the trade name of some of these types of neutral surfactants based on polyethyleneglycol-polypropyleneglycol. The structure of the organosiliceous material resulting therefrom can be identical to those found described in the literature as MCM and SBA-15. By means of this methodology, materials are obtained which, having an amorphous or crystalline structure of silicon dioxide and organosilanes, present an extraordinary periodicity in the distribution of channels and pores in such a way that, owing to this regularity, a characteristic X.-ray diffraction pattern is produced. The channels have a regular size of the order of nanometres (mesopores) and a very high surface area of greater than 500 m² x g⁻¹.

The present invention seeks to avoid, or at least reduce, the problem of oxygen inhibition and degradation of electroluminescent organic compounds in the presence of atmospheric agents.

### DESCRIPTION OF THE INVENTION

The present invention relates to an electroluminescent organic-inorganic hybrid material which is characterised in that it comprises:
- at least one microporous or mesoporous solid having a structure that is selected from among the structures of zeolites, porous oxides, molecular sieves, silicoaluminophosphates and aluminosilicates, and
- at least one organic compound which confers electroluminescent properties thereto, and in which said organic compound is a polycyclic aromatic hydrocarbon, at least part of which is joined to the structure of the microporous or mesoporous solid by means of covalent bonds.

In this material, a protection of the polycyclic aromatic hydrocarbon is produced which confers electroluminescent properties in view of the fact that this hydrocarbon is included inside the structured microporous or mesoporous organosiliceous hybrid material, which means that attack from chemical agents present in the environment is prevented owing to a restricted diffusion and to a confinement effect.

In accordance with a preferred embodiment of the invention, at least part of the polycyclic aromatic hydrocarbon is included in the same structure of the microporous or mesoporous solid by means of covalent bonds.

In accordance with preferred embodiments of the invention, the structure of the mesoporous solid can be a silica of the type MCM, such as for example that of an MCM-41 type silica or that of an MCM-48 type silica or that of other silicas, such as for example FSM-16 type silica or SBA-15 type silica.

The polycyclic aromatic hydrocarbon can in turn be at least one derivative of 9,10-diphenylanthracene, a derivative of the group consisting of derivatives of pyrene, phenanthrene, rubrene, perylene and tetraphenylporphyrin.

In this specification, derivative of the polycyclic aromatic hydrocarbon is understood to be an aromatic hydrocarbon having substituents which possess terminal groups capable of bonding to silanol group by means of covalent bonds. Said terminal groups preferably comprise atoms selected from among oxygen, sulphur, nitrogen, silicon and combinations thereof, and more preferably yet they comprise atoms of silicon.

The electroluminescent hybrid material of the invention can furthermore contain housed in its structure one or more charge transfer complexes between a second aromatic hydrocarbon and an electron donor compound. Said second aromatic hydrocarbon can be the same as the aromatic hydrocarbon having covalent bonds with the microporous or mesoporous solid, or it can be different from the aromatic hydrocarbon having covalent bonds with the microporous or mesoporous solid.

Said electron donor compound can be selected, for example, from among amines, aromatic amines, phenols and ethers.

The present invention also refers to a method for preparing an electroluminescent organic-inorganic hybrid material comprising:
- at least one microporous or mesoporous solid having a structure that is selected from among the structures of zeolites, porous oxides, molecular sieves, silicoaluminophosphates and aluminosilicates, and
- at least one organic compound which confers electroluminescent properties thereto, and in which said organic compound is a polycyclic aromatic hydrocarbon, at least part of which is joined to the structure of the microporous or mesoporous solid by means of covalent bonds, characterised in that it comprises:

- a first stage of preparation of a precursor which comprises a polycyclic aromatic hydrocarbon included in its structure, and
- a second stage of conversion of said precursor into the electroluminescent hybrid material.

According to preferred embodiments of the method, said precursor is an organosiliceous compound which comprises the aromatic hydrocarbon.

According to particular embodiments of the method, the second stage consists of causing said precursor to react with a source of Si in the presence of a structure directing agent. Said structure directing agent can optionally be eliminated by solid liquid extraction.

The hybrid materials of the present invention can also be obtained starting from an organosiliceous precursor in which there is already present the aromatic hydrocarbon or a derivative thereof prepared - as defined earlier - by a coupling reaction catalysed by palladium followed by the addition of a source of Si, such as for example mercaptoalkyltrialcoxysilane in the presence of a structure directing agent which can then be eliminated by means of a solid-liquid extraction which is in itself conventional in the preparation of organosiliceous materials.

In a preferred embodiment of this invention, the structured mesoporous organic/inorganic hybrid materials are organosiliceous materials with a base structure of the type MCM-41 or SBA-15, but which contain a polycyclic aromatic hydrocarbon in their structure which give them an electroluminescent response.

The preparation of these solid materials can be carried out in two differentiated phases. The first is the synthesis of the organosiliceous precursor as indicated above, and the second is the preparation of the structured microporous or mesoporous solid.

The synthesis of the organosiliceous compound used as precursor of the solid material is carried out by any of the usual techniques in organic synthesis. According to particular embodiments, in order to obtain the precursor of the electroluminescent material of the present invention, a methodology is followed having general application for the preparation of any kind of aromatic organosiliceous precursor consisting of the concatenation of two reactions shown in diagrammatic form in the following equation:

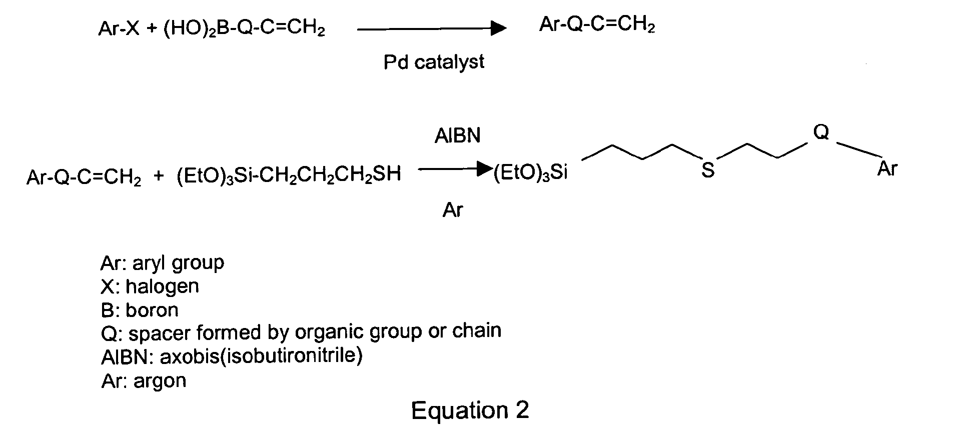

It can be seen that the first of the reactions leads to the formation of C-C bonds by means of coupling by the Suzuki-Miyaura reaction catalysed by palladium compounds and which leads to the synthesis of a suitable aromatic hydrocarbon containing vinyl groups in the periphery, while the second reaction serves to introduce trialcoxysilane groups in terminal positions and consists of the addition of mercapto groups to vinyl groups by means of a chain mechanism initiated by radicals.

Following the stage of synthesis of the organosiliceous precursor, the next step is to prepare the structured mesoporous material either by hydrolysis under acid pH conditions using Pluronic (Pluronic is a tri-block polymer which has a hydrophobic central part of propyleneglycol groups and two external parts of hydrophilic ethyleneglycol groups, a polymer with 40 ethyleneglycol groups attached to 70 propyleneglycol groups and terminated with another 40 ethyleneglycol groups - ethyleneglycol 40 propyleneglycol 70 ethyleneglycol 40 - being preferable) as structure directing agent or under basic pH conditions using cetyltrimethylammonium bromide as surfactant. In both cases, variable quantities of tetraethyl orthosilicate can be added to the organic compound as another source of silicon atoms in addition to the organic compound. The synthesis medium is water but variable quantities of other organic solvents miscible with water can be added with the aim of promoting the dissolution of the organic component in the water until a transparent gel is obtained. The addition of the components must be done at a temperature of between 0 and 20 °C with stirring and these conditions must be maintained for a period of time. Following the mixing of the components (surfactants, pH agent, organosiliceous precursor with or without tetraethyl orthosilicate), the gel is transferred to a polypropylene bottle which can be hermetically sealed and is heated to a temperature of between 80 and 120 °C for a period of several days.

The resulting solid is collected and washed exhaustively. The material thus obtained is electroluminescent, as is that resulting from extracting the structure directing agent. This extraction can be carried out using water acidulated to pH 3 with hot hydrochloric acid or an organic solvent such as 3:1 mixture of heptane/ethanol containing hydrochloric acid. The complete extraction of the structure directing agent is most commonly done by carrying out a consecutive series of extractions combining different solvents.

The structured mesoporous organosiliceous hybrid exhibits the usual characteristics of structured mesoporous silicas, namely,
i) characteristic X-ray diffraction pattern with a peak at angles less than 2.5° as a function of the distance between the centres of the channels.
ii) Isothermal adsorption of gas with a type IV profile according to the nomenclature of the IUPAC and which corresponds to mesoporous materials. The pore size varies between 2.5 and 6 nm and the BET surface area is greater than 500 m² x g⁻¹.
iii) Transmission electron microscopy images in which the apertures of the channels can be seen when the image is frontal or the parallel arrangement of the channels can be seen when the image is lateral.

In addition, these materials have the analytical and spectroscopic characteristics of organic/inorganic hybrid materials. In particular:
i) In solid state NMR-²⁹Si spectroscopy, together with the characteristic peaks of tetra- (Q⁴) and tripodal (Q³) silicons at -110 and -95 ppms, the presence can also be seen of other Si signals between -60 and -90 ppms and which correspond to those of the organic precursor which are found tri- (T³) and tetrapodally (T⁴) connected to the structure of the solid. The existence of these silicons is proof that the organosilane component is covalently bonded to the structure of the solid since the chemical displacement of the organosilane precursor in solution prior to condensing in the solid is higher than -50 ppms.
ii) In IR spectroscopy, together with the characteristic bands of the silicate, of the silanol groups and of the co-adsorbed water, vibration peaks in the aromatic region (1620-1400 cm⁻¹) are also observed indicating the presence of the aromatic component. These aromatic bands persist following the extraction of the structure directing agent and they remain unaltered when the material is heated to a temperature of 300 °C or below at a reduced pressure of 10⁻² Pa for 1 h.
iii) In UV-Vis spectroscopy recorded by the method of diffuse reflectance of the solid, absorption bands characteristic of aromatic compounds appear in the near UV or visible and can have a fine vibrational structure.
iv) In emission spectroscopy, these solids emit visible light when they are excited at the wavelength of the absorption maximum. Though shorter and with several components, the emission lifetimes are in the nanosecond range and are those corresponding to the singlet state.

Moreover, the most relevant characteristic with regard to the present invention is that these solids, as with the polycyclic aromatic compounds from which they derive, behave as electroluminescent materials. Alternatively, the phenomenon of electroluminescence can require the adsorption in this material of another component in order to form a charge transfer complex with the polycyclic aromatic component forming part of the material or with another aromatic hydrocarbon different from that forming part of the material.

In order to observe this property, a fine film of this material is arranged on a transparent conductor electrode of indium-tin oxide (ITO) and a cell is constructed with an aluminium cathode. This cell can be completed by adding other layers which inject holes or electrons in order to increase the efficacy of the electroluminescence. Equally, an electrolytic solution can be added, with polyacrylates and polyethyleneglycols being especially effective here since they improve the conductivity. In the same way, electroluminescence is observed with these materials when electroluminescent cells are prepared using any other technique constituting the state of the art in the preparation of these cells. The emission of light is observed when a direct current potential of between 2.5 and 7 V is applied to the electrodes. A fluctuating potential can also be applied.

The electroluminescent hybrid materials of the present invention has use for example in light emitting systems such as LEDs. On account of their porous composition they are also useful as gas sensors in order to determine, for example, the composition and presence of ammonia, water, carbon monoxide and other component in effluent gases.

### BRIEF DESCRIPTION OF THE FIGURES

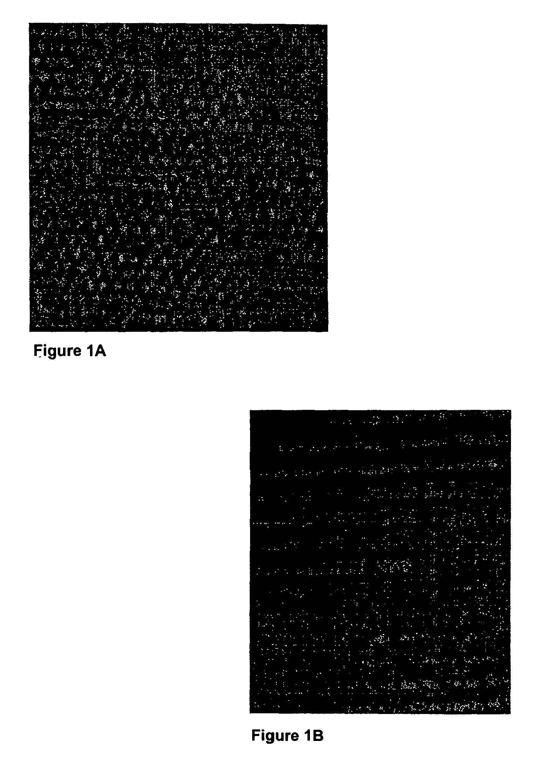

Appearing as an integral part of this descriptive specification is a series of diagrams in which figures 1A and 1B are transmission microscope images in which the material 4/MCM-41 is respectively observed with a front view and a side view of the pores;
figure 2 shows an NMR-²⁹Si spectrum of solids recorded for the sample 4/MCM-41-ex in Broker equipment at 300 MHz, in which the sample is rotating at 5 kHz in magic angle;
figure 3 shows an electroluminescence spectrum recorded with a direct current potential of 4.5 V of samples containing a polycyclic aromatic hydrocarbon covalently bonded to structures MCM-41 and SBA-15;
figure 4 shows an LED structure in which an organosiliceous hybrid material has been used.

### MODES OF EMBODYING THE INVENTION

According to a particular embodiment, an electroluminescent material is prepared containing 9,10-diarylanthracene forming part of a structured mesoporous organic/inorganic hybrid solid. The required precursor is obtained starting from 9,10-dibromoanthracene (6 g, 18 mmol) which is coupled to p-vinylphenylboronic acid (7.98 g, 54 mmol) in excess using as palladium catalyst a mixture of the complex of palladium with dibenzylideneacetone and palladium bis(tributylphosphine) (100:30 mg, respectively) in the presence of potassium carbonate (8.2 g) and in dry toluene (300 ml) as solvent. The reaction is carried out at reflux temperature, under an inert atmosphere and for a period of time of 48 hours. The reaction mixture is purified by column chromatography, with 80% of the corresponding 9,10-bis(4-vinylphenyl)anthracene being obtained.

This intermediate (2.5 mmol) is immediately made to react in toluene (10 ml) with 3-mercaptopropyltriethoxysilane (5 mmol) in an argon stream and using AIBN (1.25 mmol) as radicals initiator. The mixture is kept under magnetic stirring at 90 °C for 6 h. After that time, the solvent is evaporated at reduced pressure and the residue is exhaustively washed with hexane in order to eliminate the excess of reagents. In this way the compound 9,10bis(4-[2-(3-trimethoxysilylpropylthio)ethyl]anthracene (compound number 4 in equation 3) is obtained.

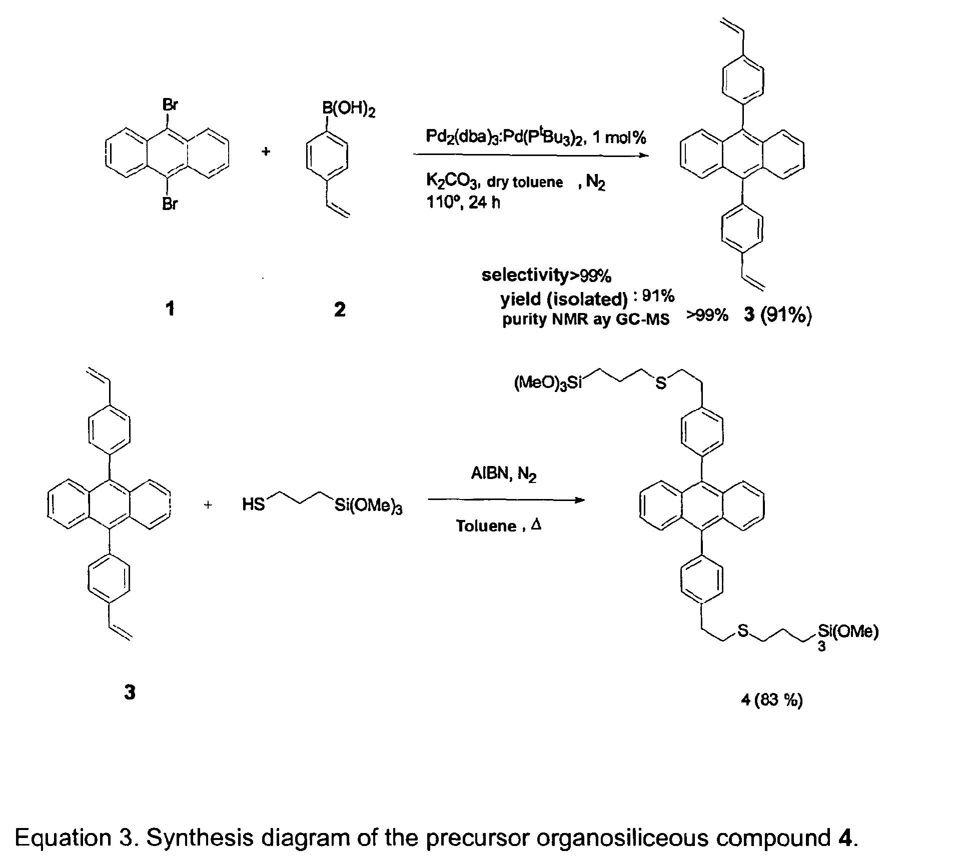

Once the precursor **4** has been obtained, it is condensed with tetraethyl silicate in the presence of cetyltrimethyl ammonium bromide (CTAB) in order to give a structured mesoporous material. The molar ratio of the preferred example contains: 1.00 Si : 0.12 CTAB : 8.0 NH₃ (28%) : 114 H₂O. The experimental procedure consists of adding the structure directing agent CTAB (0.45 g) to an aqueous solution of NH₄OH (10.349 g, 28% by weight) in deoinised water (13.75 g) and stirring the solution for 30 min in a polyethylene bottle until a homogenous solution is formed at a temperature of 10 °C. To this cold solution are added the compounds **4** (0.4 g) and tetraethyl orthosilicate (2.04 g) dissolved in 2 ml of a 1:1 mixture of acetone/water. The mixture is left to slowly reach room temperature while the stirring is continued for 2 h. After that time, the resulting gel is heated at 100 °C without stirring for 4 days. The solid resulting in these conditions is exhaustively washed with distilled water (1.5 L). The structure directing agent can be extracted by shaking the solid with an ethanol solution (10 ml per gram of solid) of 0.05 M hydrochloric acid at 50 °C for 3 h. The extraction is them immediately continued with a solution of ethanol/heptane (50:50) containing 0.15 M hydrochloric acid at 90 °C for 3 h using a solid:solvent ratio is 10:1. The resulting solids are hereafter referred to as 4/MCM-41 and 4/MCM-41-ex depending on whether they refer to the extracted or unextracted material.

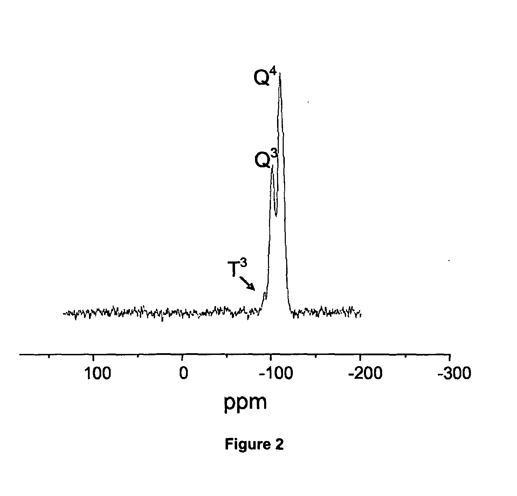

The solids 4/MCM-41 and 4/MCM-41-ex present transmission microscopy images where the presence of channels can be seen of dimensions 3 nm and having a regular distribution as shown in Figure 1.
i) In NMR-²⁹Si the signals Q⁴ and Q³ are observed corresponding to the tetra- and tripodal silicons connected to four atoms of oxygen together with a signal of lesser intensity at -75 ppm corresponding to the atoms of silicon tripodally connected to the structure of the solid and to the CH₂ group of the organic compounds (T³). One of these NMR-²⁹Si spectra is shown in Figure 2.

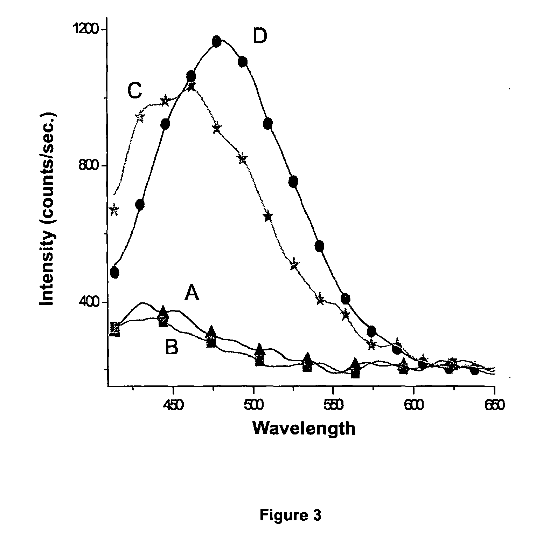

In photoluminescence spectroscopy, the solids 4/MCM-41 and 4/MCM-41-ex exhibit an emission characteristic of the anthracene group present in the structure when excited at the wavelength of the absorption maximum. Moreover, these samples emit electroluminescence when a layer of this material is taken starting from an aqueous suspension of the solid between an ITO electrode and another made of aluminium and the electrodes are subjected to a potential of 4.5 Vdc. This electroluminescent emission is also observed in other materials forming the object of the present invention, as shown in Figure 3, in which can be seen electroluminescence spectra recorded with a potential of 4.5 Vdc of the samples containing the compound 4 covalently bonded to an MCM-41 structure prior to extracting (●) and after extracting (*) the structure directing agent, and also the spectra of compound 4 forming part of the SBA-15 structure prior to extracting **(■)** and after extracting (■) the structure directing agent.

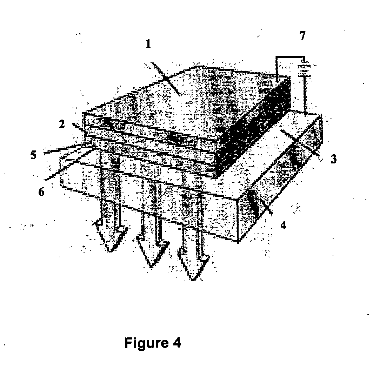

In figure 4 an OLED structure can be observed consisting of a cathode 1 in the form of a metallic layer and a crystal substrate which constitutes the anode 4. The cathode 1 and anode 4 are connected to a direct current electrical circuit 7 of between 2 and 10 V. Between the cathode 1 and the anode are an electrode transport layer 2 and an electroluminescent layer 5 which emits light in the direction of the arrows through the crystal substrate constituting the anode.

### Example 2

75 ml of an aqueous solution of 0.007 M nitric acid is prepared to which is added at 60°C and with moderate stirring 5 ml of an aqueous solution containing 4.5 mmol of the compound 9,10-anthrylene-bis(4-phenylene-propyl-thioproppyltrimethoxysilane) (compound **4**). The mixture is kept being stirred at 60 °C for between 1 and 3 minutes and 20 ml of a 1.45 M solution of ammonium hydroxide is added in order to raise the pH of the mixture and favour the condensation of the solid. The mixture is kept being stirred at the same temperature for 1 h, and finally the solid formed is collected by centrifugation (at 6000 rpm for 15 min) and it is repeatedly washed with H₂O and left to dry in a desiccator. Once dry, the resulting solid possesses a surface area of around 350-400 m² g⁻¹, with pores within the microporosity range.

## Claims

1. An electroluminescent organic-inorganic hybrid material **characterised in that** it comprises:
- at least one microporous or mesoporous solid having a structure that is selected from among the structures of zeolites, porous oxides, molecular sieves, silicoaluminophosphates and aluminosilicates, and
- at least one organic compound which confers electroluminescent properties thereto, and in which said organic compound is a polycyclic aromatic hydrocarbon, at least part of which is joined to the structure of the microporous or mesoporous solid by means of covalent bonds.

2. An electroluminescent hybrid material according to claim 1, **characterised in that** it comprises a mesoporous solid with a structure that corresponds to that of an MCM-41 type silica.

3. An electroluminescent hybrid material according to claim 1, **characterised in that** it comprises a mesoporous solid with a structure that corresponds to that of an MCM-48 type silica.

4. An electroluminescent hybrid material according to claim 1, **characterised in that** it comprises a mesoporous solid with a structure that corresponds to that of an FSM-16 type silica.

5. An electroluminescent hybrid material according to claim 1, **characterised in that** it comprises a mesoporous solid with a structure that corresponds to that of an SBA-15 type silica.

6. An electroluminescent hybrid material according to any of claims 1 to 7, **characterised in that** the aromatic hydrocarbon is a derivative of 9,10-diphenylanthracene.

7. An electroluminescent hybrid material according to any of claims 1 to 5, **characterised in that** the aromatic hydrocarbon is at least one derivative of the group consisting of derivatives of pyrene, phenanthrene, rubrene, perylene and tetraphenylporphyrin.

8. An electroluminescent hybrid material according to claim 7, **characterised in that** said derivative comprises a core selected from among pyrene, phenanthrene, rubrene, perylene and tetraphenylporphyrin bonded to substituents which have terminal groups capable of bonding to silanol groups by means of covalent bonds.

9. An electroluminescent hybrid material according to claim 8, **characterised in that** said terminal groups comprise atoms selected from among oxygen, sulphur, nitrogen, silicon and combinations thereof.

10. An electroluminescent hybrid material according to claim 9, **characterised in that** said terminal groups comprise atoms of silicon.

11. An electroluminescent hybrid material according to any of claims 1 to 7, **characterised in that** said material furthermore contains housed in its structure a charge transfer complex between a second aromatic hydrocarbon and an electron donor compound.

12. An electroluminescent hybrid material according to claim 11, **characterised in that** said second aromatic hydrocarbon is the same as the aromatic hydrocarbon having covalent bonds with the microporous or mesoporous solid.

13. An electroluminescent hybrid material according to claim 11, **characterised in that** said second aromatic hydrocarbon is different from the aromatic hydrocarbon having covalent bonds with the microporous or mesoporous solid.

14. An electroluminescent hybrid material according to claim 11, **characterised in that** said electron donor compound is selected from among amines, aromatic amines, phenols and ethers.

15. Method for preparing an electroluminescent organic-inorganic hybrid material comprising:
- at least one microporous or mesoporous solid having a structure that is selected from among the structures of zeolites, porous oxides, molecular sieves, silicoaluminophosphates and aluminosilicates, and
- at least one organic compound which confers electroluminescent properties thereto, and in which said organic compound is a polycyclic aromatic hydrocarbon, at least part of which is joined to the structure of the microporous or mesoporous solid by means of covalent bonds, **characterised in that** it comprises:
- a first stage of preparation of a precursor which comprises a polycyclic aromatic hydrocarbon included in its structure, and
- a second stage of conversion of said precursor into the electroluminescent hybrid material.

16. Method according to claim 15, **characterised in that** said precursor is an organosiliceous compound which includes the aromatic hydrocarbon.

17. Method according to claim 15, **characterised in that** the second stage consists of reacting said precursor with a source of Si in the presence of a structure directing agent.

18. Method according to claim 17, **characterised in that** the structure directing agent is eliminated by solid liquid extraction.

19. Method according to claim 15, **characterised in that** the first stage of preparation of the organosiliceous precursor comprises a coupling reaction catalysed by palladium followed by the addition of a source of Si in the presence of a structure directing agent.

20. Method according to claim 19, **characterised in** said source of Si is mercaptoalkyltrialcoxysilane.

21. Method according to claim 19, **characterised in** said structure directing agent is eliminated by means of a solid-liquid extraction.

22. An electroluminescent hybrid material according to claim 1, **characterised in that** it is a material obtained by means of a method which comprises preparing a microporous or mesoporous solid starting from a precursor which consists of a polycyclic aromatic hydrocarbon included in its structure.

23. An electroluminescent hybrid material according to claim 1, **characterised in that** it is a material obtained by means of a first stage of preparation of an organosiliceous precursor which comprises a coupling reaction catalysed by palladium followed by the addition of mercaptoalkyltrialcoxysilane in the presence of a structure directing agent, which is then eliminated by means of a solid-liquid extraction.

24. Use of an electroluminescent hybrid material defined in any of claims 1 to 14 in the manufacture of light emitting systems.

25. Use of an electroluminescent hybrid material defined in any of claims 1 to 14 as a gas sensor.
